(19) Europäisches Patentamt
European Patent Office
Office européen des brevets

(11) Veröffentlichungsnummer: **0 621 129 A1**

# (12) EUROPÄISCHE PATENTANMELDUNG

(21) Anmeldenummer: **94105531.1**

(51) Int. Cl.[5]: **B32B 27/32**

(22) Anmeldetag: **09.04.94**

(30) Priorität: **17.04.93 DE 4312543**

(43) Veröffentlichungstag der Anmeldung:
**26.10.94 Patentblatt 94/43**

(84) Benannte Vertragsstaaten:
**BE DE ES FR GB IT NL**

(71) Anmelder: **HOECHST AKTIENGESELLSCHAFT**

**D-65926 Frankfurt (DE)**

(72) Erfinder: **Peiffer, Herbert, Dr.**
**Thüringer Strasse 26**
**D-55126 Mainz (DE)**
Erfinder: **Murschall, Ursula, Dr.**
**Im Bacchuswinkel 11**
**D-55283 Nierstein (DE)**

## (54) Matte Transfermetallisierungsfolie, Verfahren zu ihrer Herstellung und ihre Verwendung.

(57) Es wird eine Polypropylen-Mehrschichtfolie beschrieben, welche mindestens eine Basisschicht, enthaltend Polypropylen und migrierende Additive oder eine Mischung aus migrierenden Additiven, und mindestens eine Deckschicht umfaßt, welche eine Mischung bzw. ein Blend zweier Komponenten I und II enthält. Die Komponente I enthält im wesentlichen ein Propylenhomopolymeres oder ein Copolymeres von Ethylen und Propylen oder Ethylen und Butylen oder Propylen und Butylen oder Ethylen und einem anderen $\alpha$-Olefin mit 5 bis 10 Kohlenstoffatomen oder Propylen und einem anderen $\alpha$-Olefin mit 5 bis 10 Kohlenstoffatomen oder ein Terpolymeres von Ethylen und Propylen und Butylen oder Ethylen und Propylen und einem anderen $\alpha$-Olefin mit 5 bis 10 Kohlenstoffatomen oder eine Mischung aus zwei oder mehreren der genannten Homo-, Co- und Terpolymeren oder ein Blend aus zwei oder mehreren der genannten Homo-, Co- und Terpolymeren, gegebenenfalls gemischt mit einem oder mehreren der genannten Homo-, Co- und Terpolymeren. Die Komponente II enthält im wesentlichen ein HDPE oder ein Blend zweier Blendkomponenten A und B. Die Blendkomponente A ist im wesentlichen ein HDPE. Die Blendkomponente B ist im wesentlichen ein Propylenhomopolymeres oder ein Copolymeres von Ethylen und Propylen oder Ethylen und Butylen oder Propylen und Butylen oder Ethylen und einem anderen $\alpha$-Olefin mit 5 bis 10 Kohlenstoffatomen oder Propylen und einem anderen $\alpha$-Olefin mit 5 bis 10 Kohlenstoffatomen oder ein Terpolymeres von Ethylen und Propylen und Butylen oder Ethylen und Propylen und einem anderen $\alpha$-Olefin mit 5 bis 10 Kohlenstoffatomen oder eine Mischung aus zwei oder mehreren der genannten Homo-, Co- und Terpolymeren oder ein Blend aus zwei oder mehreren der genannten Homo-, Co- und Terpolymeren. Die Folie ist matt.

EP 0 621 129 A1

Die Erfindung betrifft eine Polypropylen-Mehrschichtfolie, weiche mindestens eine Basisschicht, enthaltend Polypropylen und migrierende Additive oder eine Mischung aus migrierenden Additiven, und mindestens eine Deckschicht umfaßt, welche eine Mischung bzw. ein Blend zweier Komponenten I und II enthält.

Die Komponente I der Mischung bzw. des Blends ist ein Propylenhomopolymeres oder ein Copolymeres aus $\alpha$-Olefinen mit 2 bis 10 Kohlenstoffatomen oder ein Terpolymeres aus $\alpha$-Olefinen mit 2 bis 10 Kohlenstoffatomen oder eine Mischung aus zwei oder mehreren der genannten Homo-, Co- und Terpolymeren oder ein Blend aus zwei oder mehreren der genannten Homo-, Co- und Terpolymeren.

Die Komponente II der Mischung bzw. des Blends ist ein High Density Polyethylen (HDPE) oder ein Blend aus HDPE und einem oder mehreren weiteren Polymeren, ausgewählt aus der Gruppe Propylenhomopolymer, Copolymer aus $\alpha$-Olefinen mit 2 bis 10 Kohlenstoffatomen, Terpolymer aus $\alpha$-Olefinen mit 2 bis 10 Kohlenstoffatomen, und ein Blend aus Co- und Terpolymeren aus $\alpha$-Olefinen mit 2 bis 10 Kohlenstoffatomen.

Die erfindungsgemäße Deckschicht zeichnet sich durch eine charakteristische matte Oberfläche bzw. Optik aus und ist für die Verwendung als Transfermetallisierungsfolie geeignet.

Die Erfindung betrifft ferner ein Verfahren zur Herstellung der Mehrschichtfolie sowie ihre Verwendung.

Die Verpackungsindustrie hat einen hohen Bedarf an metallisierten Papieren und Kartonagen. Die Metallschicht sorgt für gute Sperreigenschaften gegen das Durchtreten von Aroma, Fett, Feuchtigkeit und Luftsauerstoff sowie für ein sehr werbewirksames Aussehen. Damit sind Papiere mit Metallschicht hervorragend als Verpackungsmaterial für Tabakartikel, Speiseeis, Konfekt, Süßigkeiten, Kaugummi oder für fetthaltige Lebensmittel wie Butter oder Käse geeignet. Weitere Anwendungsbereiche sind Kosmetikprodukte oder die Verpackung von Sterilartikeln im medizinischen Bereich. Ein weiteres Anwendungsgebiet ist der Etikettensektor. In diesen Fällen wird die Metallschicht gewöhnlich mit einem Aufdruck versehen.

Für die Herstellung der Papier-Metall-Verbundmaterialien hat sich in den letzten Jahren das Verfahren der Transfermetallisierung bewährt. Hierbei wird in einem Transferprozeß die Metallschicht von einer im Vakuum mit Metall bedampften Polypropylenfolie auf das Papier übertragen. Im einzelnen besteht dieser Prozeß aus den folgenden Teilschritten: Kontinuierliche Metallisierung der Folienbahn durch Aufdampfen der Metallschicht, Beschichtung der Metallschicht auf der Folie oder des zu metallisierenden Papiers mit einem Klebstoff, Kaschierung von metallisierter Folie und Papier zum Verbund Folie-Metall-Klebstoff-Papier, Aushärtung des Klebstoffs, Delaminierung des Verbunds, d. h. Trennung an der Grenzschicht Metall-Folie durch Abziehen der Folie. Die als Metallüberträger verwendete Folie wird anschließend aufgewickelt und steht damit für eine erneute Metallisierung zur Verfügung. Durch die Verwendung geeigneter Rezepturen besteht die Möglichkeit, die Folie mehr als 40mal zu metallisieren.

Durch die Transfermetallisierung erhält man Papier mit einer sehr glatten, spiegelnden und hochglänzenden metallischen Oberfläche. Wegen dieser dekorativen Eigenschaft wird es häufig für hochwertiges Geschenkpapier, Glückwunschkarten und Verpackungen genutzt, bei denen die Metallschicht mit einem Aufdruck versehen wird.

Für andere Anwendungsgebiete besteht dagegen ein Bedarf, der Metallschicht des Papier-Metall-Verbunds eine mattglänzende oder strukturierte Oberfläche zu verleihen oder Oberflächenbereiche mit unterschiedlich starkem Glanz zu schaffen.

Die deutsche Patentanmeldung P 41 35 096.0 offenbart Polyolefin-Mehrschichtfolien aus einer Polypropylen-Basisschicht und einer Deckschicht aus einem HDPE-Blend. Dieses HDPE-Blend besteht aus HDPE und Co- und/oder Terpolymeren aus $\alpha$-Olefinen und gegebenenfalls Polypropylen. Die Deckschicht der Mehrschichtfolie weist einen minimalen Glanz und eine maximale Trübung auf, wodurch der Folie ein charakteristisches mattes Aussehen verliehen wird.

Eine beidseitig siegelbare, biaxial orientierte Polyolefinfolie mit drei Schichten ist aus der US-A-4 419 411 bekannt. Bei diesen Folien ist in beiden Siegelschichten Polysiloxan und Siliciumdioxid als Additivkombination inkorporiert. Die Basisschicht besteht im wesentlichen aus Polypropylen und enthält eine geringe Menge Monocarbonsäureamid, welches teilweise von der Basisschicht in die beiden Siegelschichten migriert. Die beschriebene Polyolefin-Mehrschichtfolie soll einen besonders niedrigen Reibungskoeffizienten aufweisen.

Aus der US-A-4 578 316 ist eine biaxial orientierte Polyolefin-Mehrschichtfolie bekannt, deren Basisschicht aus einem Polypropylen-Homopolymeren und deren Deckschicht aus einem Blend von Polypropylen und MDPE und/oder HDPE besteht. Diese Polyolefinfolie besitzt einen niedrigen Reibungskoeffizienten in Verbindung mit einer gut benetzbaren Oberfläche; jedoch weist auch dieser Film eine ausgezeichnete optische Klarheit auf.

In der WO 89/10839 werden Polyolefin-Mehrschichtfolien beschrieben, deren Basisschicht aus einem Polypropylenpolymeren und deren Deckschichten entweder aus HDPE oder einem Ethylen-Propylen-Copolymeren oder einem Polypropylen bestehen, wobei die Folie bei speziellen Temperaturbedingungen

gestreckt wird. Sie besitzt insbesondere einen niedrigen Reibungskoeffizienten und eine gute Benetzbarkeit, aber gleichzeitig auch einen hohen Glanz und eine geringe Trübung.

Die EP-A-0 367 613 offenbart eine Mehrschichtfolie aus einer vakuolenhaltigen Polypropylen-Basisschicht und einer Deckschicht, welche beschriftbar ist und ein erstes Polymer mit einem Schmelzflußindex von ≦1 g/10 min und ein zweites Polymeres enthält, welches mit dem besagten ersten Polymeren inkompatibel ist. Als Beispiel für das erste Polymer ist ein HDPE mit einer Dichte von 0,92 bis 0,97 g/cm$^3$ beschrieben. Das inkompatible Polymer ist ein Polypropylen oder Copolymere des Propylens oder Terpolymere des Propylens. Die beschriebene Folie hat ein opakes Aussehen, d. h. sie ist im wesentlichen lichtundurchlässig. Die beschriebene Folie weist eine Dichte von 0,69 g/cm$^3$ auf. Diese Folie ist für viele Verwendungszwecke aufgrund ihrer Opazität nicht einzusetzen.

Die EP-A-0 352 463 beschreibt eine biaxial streckorientierte Folie aus einer Basisschicht mit beidseitigen Deckschichten und inerten Zusatzmitteln, insbesondere anorganischen Zusatzstoffen. Die drei Schichten sind aus Polyolefin aufgebaut, und die Basisschicht enthält Additive, die aus der Basisschicht in die Deckschichten migrieren. Die Folie ist geeignet für das Verfahren der Transfermetallisierung. Die Basisschicht enthält das inerte Zusatzmittel in Form von fein verteilten Teilchen. Diese Teilchen ragen teilweise aus der Basisschicht heraus und sind von den Deckschichten vollständig überzogen. Dabei weist wenigstens eine der beiden äußeren Oberflächen der Deckschichten zumindest in Teilbereichen infolge der aus der Basisschicht herausragenden Teilchen eine erhöhte Rauhigkeit auf. Die Folie zeichnet sich durch eine hohe Wiederverwendungsrate und verbesserte Bedruckbarkeit der übertragenen Metallschicht aus. Es ist beschrieben, daß die Folie die Möglichkeit bietet, der übertragenen Metallschicht einen verringerten Glanz zu verleihen.

Die EP-A-0 175 259 beschreibt eine biaxial streckorientierte Transfermetallisierungsfolie auf Basis von Polypropylen. Die Folie ist eine durch Coextrusion hergestellte Dreischichtfolie umfassend eine Basisschicht aus Propylenhomopolymerem und beidseitig darauf aufgebrachten Deckschichten. Die Basisschicht enthält ein Additivdepot von migrierenden Monomeren in einer Menge von 0,01 bis 2,0 Gew.-%, bezogen auf das Gewicht des die Basisschicht bildenden Polymeren. Die Deckschichten bestehen aus Polypropylen, das eine niedrigere Viskosität aufweist als das Polypropylen der Basisschicht.

Alle bekannten Transfermetallisierungsfolien sind verbesserungsbedürftig bezüglich der Optik der übertragenen Metallschicht. Nach dem Stand der Technik sind die Metallschichten glänzend bis hochglänzend, was für bestimmte Verwendungszwecke nachteilig ist. Die Gleichmäßigkeit der übertragenen Metallschicht läßt häufig zu wünschen übrig, besonders häufig treten Störstellen in Form sogenannter Blitzfiguren auf. Durch die mangelhaften antistatischen Eigenschaften kommt es zu einer starken Aufladung auf der Folienoberfläche, die wiederum zu plötzlichen Entladungen führen kann. Die Entladungen erzeugen an einzelnen Stellen der Folienoberfläche eine erhöhte Oberflächenspannung in Form der besagten Blitzfiguren. Diese Blitzfiguren sind an der Folie selbst mit bloßem Auge nicht wahrnehmbar. Bei der Metallisierung kommt es jedoch an diesen Stellen zu einer veränderten Metallhaftung, so daß die Blitzfiguren in der übertragenen Metallschicht abgebildet werden.

Weiterhin sind die bekannten Folien verbesserungsbedürftig bezüglich ihrer Konfektionierbarkeit. Transfermetallisierungsfolien werden bis zu 40mal verwendet, d. h. auch 40mal neu aufgewickelt. Dabei dürfen keine Wickelfehler auftreten, insbesondere kein Teleskopieren der Rollen und keine Verdehnungen. Diese Probleme treten besonders gehäuft bei breiten Rollen, d. h. bei solchen von über 1,5 µm Breite auf.

Die Aufgabe der vorliegenden Erfindung bestand daher darin, eine Mehrschichtfolie zur Verfügung zu stellen, die durch ein mattes Erscheinungsbild mindestens einer Oberfläche gekennzeichnet ist. Die Trübung und der Glanz der Oberfläche/n sollen im Hinblick auf diese gewünschte matte Charakteristik optimiert sein. Dabei ist gleichzeitig eine homogene Folienoptik ohne fleckige oder streifige Störstellen wichtig, um eine gleichmäßige Metallisierbarkeit und eine gleichmäßig übertragene Metallschicht zu ermöglichen. Zusätzlich ist eine gute Bedruckbarkeit der übertragenen Metallschicht gefordert. Die Folie soll gute antistatische Eigenschaften und möglichst keine oder wenige Blitzfiguren aufweisen. Sie soll häufig wiederverwendbar und gut konfektionierbar sein.

Erfindungsgemäß wird diese Aufgabe gelöst durch eine Mehrschichtfolie der eingangs genannten Gattung, wobei

die Komponente I im wesentlichen

ein Propylenhomopolymeres oder ein Copolymeres von
Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder

ein Terpolymeres von
Ethylen und Propylen und Butylen oder
Ethylen und Propylen und einem anderen α-Olefin mit 5 bis 10 Kohlenstoffatomen oder
eine Mischung aus zwei oder mehreren der genannten Homo-, Co- und Terpolymeren oder
ein Blend aus zwei oder mehreren der genannten Homo-, Co- und Terpolymeren, gegebenenfalls gemischt mit einem oder mehreren der genannten Homo-, Co- und Terpolymeren,
enthält und
die Komponente II im wesentlichen ein HDPE oder ein Blend zweier Blendkomponenten A und B enthält, wobei
die Blendkomponente A im wesentlichen
ein HDPE ist und
die Blendkomponente B im wesentlichen
ein Propylenhomopolymeres oder
ein Copolymeres von
Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder
ein Terpolymeres von
Ethylen und Propylen und Butylen oder
Ethylen und Propylen und einem anderen α-Olefin mit 5 bis 10 Kohlenstoffatomen oder
eine Mischung aus zwei oder mehreren der genannten Homo-, Co- und Terpolymeren oder
ein Blend aus zwei oder mehreren der genannten Homo-, Co- und Terpolymeren
ist und die Folie matt ist.

Unter Mischungen im Sinne der vorliegenden Erfindung sind mechanische Mischungen zu verstehen, welche aus den Einzelkomponenten hergestellt werden. Im allgemeinen werden hierzu die einzelnen Bestandteile als gepreßte Formkörper kleiner Größe, z. B. linsen- oder kugelförmiges Granulat, zusammengeschüttet und mit einer geeigneten Rüttelvorrichtung mechanisch gemischt.

Ein Blend im Sinne der vorliegenden Erfindung ist ein legierungsartiger Verbund der einzelnen Komponenten, welcher nicht mehr in die ursprünglichen Bestandteile zerlegt werden kann. Ein Blend weist Eigenschaften wie ein homogener Stoff auf und kann entsprechend durch geeignete Parameter charakterisiert werden.

Die Basisschicht der erfindungsgemäßen Mehrschichtfolie besteht im wesentlichen aus einem Propylenpolymer und migrierenden Additiven oder Mischungen aus migrierenden Additiven. Das Propylenpolymere enthält zum überwiegenden Teil (mindestens 90 %) Propylen und besitzt einen Schmelzpunkt von 140 °C oder höher, vorzugsweise 150 bis 170 °C. Isotaktisches Homopolypropylen mit einem n-heptanlöslichen Anteil von 6 Gew.-% und weniger, bezogen auf das isotaktische Homopolypropylen, Copolymere von Ethylen und Propylen mit einem Ethylengehalt von 5 Gew.-% oder weniger, Copolymere von Propylen mit $C_4$-$C_8$-α-Olefinen mit einem α-Olefingehalt von 5 Gew.-% oder weniger stellen bevorzugte Propylenpolymere für die Basisschicht dar, wobei isotaktisches Polypropylen besonders bevorzugt ist. Das Propylenpolymere der Basisschicht hat im allgemeinen einen Schmelzflußindex von 0,5 g/10 min bis 10 g/10 min, vorzugsweise 1,5 g/10 min bis 4 g/10 min, bei 230 °C und einer Kraft von 21,6 N (DIN 53 735). Die angegebenen Gewichtsprozente beziehen sich auf das jeweilige Copolymer. Die migrierenden Additive der Basisschicht sollen die Struktur der Basisschicht nicht verändern. Insbesondere werden keine Füllstoffe von dem Begriff "Additive" umfaßt. Füllstoffe umfassen nach allgemeiner Terminologie partikelförmige Zusatzstoffe, welche vakuolenartige Leerräume in der Schicht erzeugen. Die erfindungsgemäße Folie weist eine im wesentlichen transparente, d. h. eine nicht vakuolenhaltige Basisschicht auf.

Die Basisschicht enthält migrierende Additive oder eine Mischung aus migrierenden Additiven. Migrierende Additive umfassen im Sinne der vorliegenden Erfindung Verbindungen, welche in der Lage sind, nach und nach aus der Basisschicht in die Deckschicht überzutreten und bis auf die äußere Oberfläche der Folie zu gelangen, wo sie ihre Wirkung entfalten. Als migrierende Additive sind tertiäre aliphatische Amine und Fettsäureamide bevorzugt.

Tertiäre aliphatische Amine sind Verbindungen der Formel I

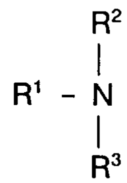

worin

$R^1$ einen hydroxysubstituierten Alkylrest mit 1 bis 6 C-Atomen, vorzugsweise einen 2-Hydroxyethylrest, und

$R^2$ und $R^3$ gleich oder verschieden sein können und einen langkettigen Alkylrest mit 10 bis 20 C-Atomen, vorzugsweise 12 bis 18 C-Atomen,

bedeuten.

Die langkettigen Alkylreste $R^2$ und $R^3$ sind vorzugsweise im wesentlichen unverzweigt und im wesentlichen gesättigt. Als besonders vorteilhaft haben sich N,N-bis(2-hydroxyethyl)-alkylamine mit 12 bis 18 C-Atomen im Alkylrest erwiesen.

Fettsäureamide sind Verbindungen der Formel II

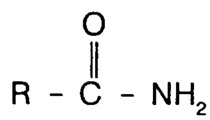

worin R einen langkettigen aliphatischen Alkylrest mit 10 bis 20 C-Atomen bedeutet. Der Alkylrest R ist vorzugsweise im wesentlichen unverzweigt und im wesentlichen gesättigt. Ein besonders geeignetes Fettsäureamid ist Stearinsäureamid.

Die migrierenden Additive werden der Basisschicht im allgemeinen in einer Menge von 0,05 bis 2 Gew.-%, vorzugsweise 0,1 bis 1 Gew.-%, insbesondere >0,3 bis 1 Gew.-%, bezogen auf die Basisschicht, zugesetzt. Diese Mengenangaben beziehen sich auf die Gesamtmenge an migrierendem Additiv, d. h. insbesondere auf die Menge an tertiärem alipatischem Amin oder auf die Menge an Fettsäureamid.

In einer besonders vorteilhaften Ausführungsform wird der Basisschicht eine Mischung aus verschiedenen migrierenden Additiven zugesetzt, bevorzugt eine Mischung aus den vorstehend beschriebenen tertiären aliphatischen Aminen und Fettsäureamiden. Eine Mischung aus N,N-bis(2-hydroxyethyl)-alkylaminen mit Alkylresten mit 12 bis 18 C-Atomen und Stearinsäureamid ist besonders bevorzugt.

Das Verhältnis von Amin zu Amid kann innerhalb weiter Grenzen variieren. Der Anteil an Amin liegt im Bereich von 30 bis 70 Gew.-%, vorzugsweise im Bereich von 40 bis 60 Gew.-%, jeweils bezogen auf die Mischung aus Amin und Amid. Der Amidanteil variiert selbstverständlich entsprechend.

Mindestens eine Deckschicht der erfindungsgemäßen Mehrschichtfolie enthält eine im folgenden näher beschriebene Mischung zweier Komponenten I und II und gegebenenfalls zugesetzte Additive.

Die Komponente I der Deckschichtmischung bzw. des Blends enthält im wesentlichen
ein Propylenhomopolymer oder
ein Copolymer von
Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder
ein Terpolymer von
Ethylen und Propylen und Butylen oder
Ethylen und Propylen und einem anderen α-Olefin mit 5 bis 10 Kohlenstoffatomen oder
eine Mischung aus zwei oder mehreren der genannten Homo-, Co- und Terpolymeren oder
ein Blend aus zwei oder mehreren der genannten Homo-, Co- und Terpolymeren, gegebenenfalls gemischt mit einem oder mehreren der genannten Homo-, Co- und Terpolymeren.

Besonders bevorzugt besteht die Komponente I im wesentlichen aus
einem Propylenhomopolymeren oder aus
einem Copolymeren von

Ethylen und Propylen oder
Ethylen und Butylen-1 oder
Propylen und Butylen-1 oder aus
einem Terpolymeren von
Ethylen und Propylen und Butylen-1 oder aus
einer Mischung aus zwei oder mehreren der genannten besonders bevorzugten Homo-, Co- und Terpolymeren oder aus
einem Blend aus zwei oder mehreren der genannten besonders bevorzugten Homo-, Co- und Terpolymeren, gegebenenfalls gemischt mit einem oder mehreren der genannten Homo-, Co- und Terpolymeren, wobei insbesondere Propylenhomopolymer oder
statistische Ethylen-Propylen-Copolymere mit
einem Ethylengehalt von 2 bis 10 Gew.-%, bevorzugt 5 bis 8 Gew.-%, oder
statistische Propylen-Butylen-1-Copolymere mit
einem Butylengehalt von 4 bis 25 Gew.-%, bevorzugt 10 bis 20 Gew.-%,
jeweils bezogen auf das Gesamtgewicht des Copolymeren, oder statistische Ethylen-Propylen-Butylen-1-Terpolymere mit
einem Ethylengehalt von 1 bis 10 Gew.-%, bevorzugt 2 bis 6 Gew.-%, und
einem Butylen-1-Gehalt von 3 bis 20 Gew.-%, bevorzugt 8 bis 10 Gew.-%,
jeweils bezogen auf das Gesamtgewicht des Terpolymeren, oder ein Blend aus einem Ethylen-Propylen-Butylen-1-Terpolymeren und einem Propylen-Butylen-1-Copolymeren
mit einem Ethylengehalt von 0,1 bis 7 Gew.-%
und einem Propylengehalt von 50 bis 90 Gew.-%
und einem Butylen-1-Gehalt von 10 bis 40 Gew.-%,
jeweils bezogen auf das Gesamtgewicht des Polymerblends, bevorzugt sind.

Das als oder in der Komponente I eingesetzte Propylenhomopolymere enthält zum überwiegenden Teil (mindestens 90 %) Propylen und besitzt einen Schmelzpunkt von 140 °C oder höher, vorzugsweise 150 bis 170 °C, wobei isotaktisches Homopolypropylen mit einem n-heptanlöslichen Anteil von 6 Gew.-% und weniger, bezogen auf das isotaktische Homopolypropylen, bevorzugt ist. Das Homopolymere der Komponente I bzw. das in dieser enthaltene Homopolymere hat im allgemeinen einen Schmelzflußindex von 0,5 g/10 min bis 15 g/10 min, vorzugsweise 1,5 g/10 min bis 6 g/10 min, bei 230 °C und einer Kraft von 21,6 N (DIN 53 735).

Die Komponente II der Deckschichtmischung enthält im wesentlichen ein HDPE oder ein Blend, welches im wesentlichen HDPE als Blendkomponente A und eine Blendkomponente B umfaßt.

Unter HDPE werden im Sinne der vorliegenden Erfindung Hochdruckpolyethylene verstanden, welche die folgenden Eigenschaften aufweisen:

1. Der Schmelzflußindex MFI, gemessen nach DIN 53 735 oder ISO 1133 bei 50 N/190 °C, liegt im Bereich von 0,2 bis 50 g/10 min, vorzugsweise größer 1 bis 45 g/10 min, insbesondere 5 bis 35 g/10 min.
2. Die Viskositätszahl, gemessen nach DIN 53 728, Teil 4, oder ISO 1191, liegt im Bereich von 100 bis 450 $cm^3/g$, vorzugsweise 120 bis 280 $cm^3/g$.
3. Die Kristallinität beträgt 35 bis 80 %, vorzugsweise 50 bis 80 %.
4. Die Dichte, gemessen bei 23 °C nach DIN 53 479, Verfahren A, oder ISO 1183, liegt im Bereich von 0,93 bis 0,97 $g/cm^3$, vorzugsweise 0,95 bis 0,96 $g/cm^3$.
5. Der Schmelzpunkt, gemessen mit DSC (Maximum der Schmelzkurve, Aufheizgeschwindigkeit 20 °C/min), liegt zwischen 120 und 150 °C, vorzugsweise zwischen 125 und 135 °C).

Das HDPE als Komponente II als auch HDPE als Blendkomponente A wird aus den vorstehend beschriebenen Polyethylenen ausgewählt, so daß als Komponente II grundsätzlich das gleiche HDPE wie als Blendkomponente A in Frage kommt.

Die Blendkomponente B besteht im wesentlichen aus
einem Propylenhomopolymeren oder aus
einem Copolymeren von
Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder aus
einem Terpolymeren von
Ethylen und Propylen und Butylen oder

Ethylen und Propylen und einem anderen α-Olefin mit 5 bis 10 Kohlenstoffatomen oder aus
einer Mischung aus zwei oder mehreren der genannten Homo-, Co- und Terpolymeren oder aus
einem Blend aus zwei oder mehreren der genannten Homo-, Co- und Terpolymeren.

Besonders bevorzugt besteht die Blendkomponente B im wesentlichen aus
einem Propylenhomopolymeren oder aus
einem Copolymeren von
Ethylen und Propylen oder
Ethylen und Butylen-1 oder
Propylen und Butylen-1 oder aus
einem Terpolymeren von
Ethylen und Propylen und Butylen-1 oder aus
einer Mischung aus zwei oder mehreren der genannten besonders bevorzugten Homo-, Co- und Terpolymeren oder aus
einem Blend aus zwei oder mehreren der genannten besonders bevorzugten Homo-, Co- und Terpolymeren,
wobei insbesondere Propylenhomopolymer oder
statistische Ethylen-Propylen-Copolymere mit
einem Ethylengehalt von 2 bis 10 Gew.-%, bevorzugt 5 bis 8 Gew.-%, oder
statistische Propylen-Butylen-1-Copolymere mit
einem Butylengehalt von 4 bis 25 Gew.-%, bevorzugt 10 bis 20 Gew.-%,
jeweils bezogen auf das Gesamtgewicht des Copolymeren, oder
statistische Ethylen-Propylen-Butylen-1-Terpolymere mit einem Ethylengehalt von 1 bis 10 Gew.-%, bevorzugt 2 bis 6 Gew.-%, und
einem Butylen-1-Gehalt von 3 bis 20 Gew.-%, bevorzugt 8 bis 10 Gew.-%,
jeweils bezogen auf das Gesamtgewicht des Terpolymeren, oder ein Blend aus einem Ethylen-Propylen-Butylen-1-Terpolymeren und einem Propylen-Butylen-1-Copolymeren
mit einem Ethylengehalt von 0,1 bis 7 Gew.-%
und einem Propylengehalt von 50 bis 90 Gew.-%
und einem Butylen-1-Gehalt von 10 bis 40 Gew.-%,
jeweils bezogen auf das Gesamtgewicht des Polymerblends, bevorzugt sind.

Das als oder in der Blendkomponente B eingesetzte Propylenhomopolymere enthält zum überwiegenden Teil (mindestens 90 %) Propylen und besitzt einen Schmelzpunkt von 140 °C oder höher, vorzugsweise 150 bis 170 °C, wobei isotaktisches Homopolypropylen mit einem n-heptanlöslichen Anteil von 6 Gew.-% und weniger, bezogen auf das isotaktische Homopolypropylen bevorzugt ist. Das Homopolymere der Blendkomponente B bzw. das in dieser enthaltene Homopolymere hat im allgemeinen einen Schmelzflußindex von 0,5 g/10 min bis 15 g/10 min, vorzugsweise 1,5 g/10 min bis 6 g/10 min, bei 230 °C und einer Kraft von 21,6 N (DIN 53 735).

Das Verhältnis (Gewichtsverhältnis) der beiden Blendkomponenten A und B liegt zwischen A:B = 20:80 und A:B = 80:20, vorzugsweise zwischen A:B = 40:60 und A:B = 60:40, und liegt insbesondere bevorzugt bei A:B = 45:55.

Das Blend aus den Komponenten A und B hat einen Schmelzflußindex (DIN 53 735 bei 230 °C und 21,6 N Belastung) von 1,5 g/10 min bis 12 g/10 min, vorzugsweise von 2,5 g/10 min bis 6 g/10 min, wobei der Schmelzflußindex des Blends bevorzugt höher liegt als jener des Propylenpolymeren der Basisschicht. Der Schmelzbereich des Blends liegt zwischen 100 und 160 °C, vorzugsweise zwischen 120 und 150 °C.

Das Verhältnis (Gewichtsverhältnis) der beiden Komponenten I und II der Deckschichtmischung bzw. des Blends kann innerhalb weiter Grenzen variieren und richtet sich nach dem beabsichtigten Einsatzzweck der Mehrschichtfolie. Bevorzugt liegt das Verhältnis der Komponenten I und II in einem Bereich von I:II = 10:90 bis I:II = 90:10, vorzugsweise zwischen I:II = 30:70 bis I:II = 70:30, insbesondere bei I:II = 50:50.

In einer weiteren Ausführungsform enthält die vorstehend beschriebene Deckschicht zusätzlich Füllstoffe. Füllstoffe umfassen feste Teilchen mit einem mittleren Teilchendurchmesser von ≧1 µm, vorzugsweise 1 bis 6 µm.

Übliche Füllstoffe der Deckschicht sind anorganische und/oder organische, mit Polypropylen unverträgliche Materialien wie Aluminiumoxid, Aluminiumsulfat, Bariumsulfat, Calciumcarbonat, Magnesiumcarbonat, Silicate wie Aluminiumsilicat (Kaolinton) und Magnesiumsilicat (Talkum) und Siliciumdioxid, worunter Calciumcarbonat und Siliciumdioxid bevorzugt eingesetzt werden. Als organische Füllstoffe kommen die üblicherweise verwendeten, mit dem Polymeren der Basisschicht unverträglichen Polymeren in Frage, insbesondere solche wie HDPE, Polyester, Polystyrole, Polyamide, halogenierte organische Polymere, wobei Polyester wie beispielsweise Polybutylenterephthalate bevorzugt sind. "Unverträgliche Materialien bzw.

unverträgliche Polymere" im Sinne der vorliegenden Erfindung bedeutet, daß das Material bzw. das Polymere in der Folie als separates Teilchen bzw. als separate Phase vorliegt.

Die Füllstoffmenge der Deckschicht beträgt bis zu 15 Gew.-% und liegt im allgemeinen in einem Bereich von 1 bis 10 Gew.-%, vorzugsweise im Bereich von 3 bis 5 Gew.-%, jeweils bezogen auf die Deckschicht.

Bevorzugt wird diesen füllstoffhaltigen Ausführungsformen der Folie $SiO_2$ als festes Teilchen in der Deckschicht zugesetzt. $SiO_2$ wird im allgemeinen durch Mahlung von Silica-Gel hergestellt und ist eine synthetisch hergestellte hochporöse reine Kieselsäure, welche eine völlig amorphe Struktur im Gegensatz zu kristallinen Kieselsäuren aufweist. Der $SiO_2$-Gehalt liegt im allgemeinen über 95 %, insbesondere im Bereich von 98 bis 99,5 %.

Zur Verwendung ist grobkörniges $SiO_2$ mit einem mittleren Teilchendurchmesser von 3 bis 5 $\mu$m oder feinkörniges $SiO_2$ mit einem mittleren Teilchendurchmesser von 1 bis 2,5 $\mu$m oder eine Mischung aus grobkörnigem und feinkörnigem $SiO_2$ geeignet.

In einer besonders vorteilhaften Ausführungsform sind die $SiO_2$-Teilchen mit einem mittleren Teilchendurchmesser von 3 bis 5 $\mu$m organisch nachbehandelt und weisen eine Beschichtung auf, welche 0,5 bis 5 % einer aliphatischen Carbonsäure enthält. Als aliphatische Carbonsäuren sind aliphatische Hydroxydi- und -tricarbonsäuren oder Stearinsäure bevorzugt. Im allgemeinen weisen die Säuren zwei bis fünf, bevorzugt zwei bis drei, Hydroxygruppen auf. Als aliphatische Carbonsäuren sind Tartronsäure (Hydroxymalonsäure), Äpfelsäure (Monohydroxybernsteinsäure), Weinsäure (Dihydroxybernsteinsäure) und Citronensäure bevorzugt. Als ganz besonders vorteilhaft haben sich citronensäurehaltige Beschichtungen erwiesen. Aufgrund der organischen Beschichtung reagieren die grobkörnigen $SiO_2$-Teilchen in wäßrigen Lösungen leicht sauer. Der pH-Wert einer 5%igen wäßrigen Suspension liegt in einem Bereich von 3 bis 5, bevorzugt beträgt er 4.

Der Gehalt an grobkörnigem Antiblockmittel, insbesondere des $SiO_2$, liegt im Bereich von 0,05 bis 0,4 Gew.-%, vorzugsweise 0,1 bis 0,25 Gew.-%, bezogen auf die Deckschicht.

Das zweite, feinkörnige Antiblockmittel hat einen mittleren Teilchendurchmesser von 1 bis 2,5 $\mu$m, vorzugsweise etwa 2 $\mu$m. Als feinkörniges Antiblockmittel ist ebenfalls $SiO_2$ bevorzugt, wobei dieses im allgemeinen ohne organische Nachbehandlung eingesetzt wird. Der Gehalt in der Deckschicht beträgt 0,05 bis 0,4 Gew.-%, vorzugsweise 0,1 bis 0,25 Gew.-%.

Die erfindungsgemäße Mehrschichtfolie umfaßt zumindest die vorstehend beschriebene Basisschicht und mindestens eine matte Deckschicht, welche die vorstehend beschriebene Mischung bzw. Blend enthält. Je nach ihrem vorgesehenen Verwendungszweck kann die Mehrschichtfolie eine weitere Deckschicht auf der gegenüberliegenden Seite aufweisen. Gegebenenfalls kann/können auch eine oder mehrere Zwischenschicht/en zwischen der Basis- und der/den Deckschicht/en aufgebracht werden.

Aufbau, Dicke und Zusammensetzung einer zweiten Deckschicht können unabhängig von der bereits vorhandenen erfindungsgemäßen matten Deckschicht gewählt werden. Bevorzugte Ausführungsformen der Mehrschichtfolie sind dreischichtig, wobei die zweite Deckschicht ebenfalls eine der vorstehend beschriebenen Mischungen enthalten kann, welche aber nicht mit der der ersten Deckschicht identisch sein muß. Die zweite Deckschicht kann jedoch auch jedes andere gängige Deckschichtpolymer enthalten.

Die Dicke der matten Deckschicht/en ist größer als 0,4 $\mu$m und liegt vorzugsweise im Bereich von 0,8 bis 4 $\mu$m, insbesondere 1 bis 3 $\mu$m, wobei beidseitige Deckschichten gleich oder verschieden dick sein können.

Die Gesamtdicke der erfindungsgemäßen Polyolefin-Mehrschichtfolie kann innerhalb weiter Grenzen variieren und richtet sich nach dem beabsichtigten Einsatz. Sie beträgt vorzugsweise 5 bis 70 $\mu$m, insbesondere 10 bis 50 $\mu$m, wobei die Basisschicht etwa 50 bis 90 % der Gesamtfoliendicke ausmacht.

Die Dichte der erfindungsgemäßen Folie beträgt mindestens 0,8 g/cm$^3$ und liegt bevorzugt im Bereich von 0,9 bis 0,92 g/cm$^3$.

Zur Verbesserung der Hafteigenschaften der Deckschicht/en ist mindestens eine Oberfläche der Folie corona- oder flammbehandelt, wobei gegebenenfalls die entsprechende Behandlung an beiden Oberflächen vorgenommen werden kann.

Um bestimmte Eigenschaften der erfindungsgemäßen Polypropylenfolie noch weiter zu verbessern, können sowohl die Basisschicht als auch die Deckschicht/en weitere Zusätze in einer jeweils wirksamen Menge enthalten, vorzugsweise Stabilisatoren und/oder Neutralisationsmittel, die mit den Polymeren der Basisschicht und der Deckschicht/en verträglich sind. Alle Mengenangaben in der folgenden Ausführung in Gewichtsprozent (Gew.-%) beziehen sich jeweils auf die Schicht oder Schichten, der oder denen das Additiv zugesetzt sein kann.

Als Stabilisatoren können die üblichen stabilisierend wirkenden Verbindungen für Ethylen-, Propylen- und andere $\alpha$-Olefinpolymere eingesetzt werden. Deren Zusatzmenge liegt zwischen 0,05 und 2 Gew.-%.

Besonders geeignet sind phenolische Stabilisatoren, Alkali-/Erdalkalistearate und/oder Alkali-/Erdalkalicarbonate.

Phenolische Stabilisatoren werden in einer Menge von 0,1 bis 0,6 Gew.-%, insbesondere 0,15 bis 0,3 Gew.-%, und mit einer Molmasse von mehr als 500 g/mol bevorzugt. Pentaerythrityl-Tetrakis-3-(3,5-di-Tertiärbutyl-4-Hydroxyphenyl)-Propionat oder 1,3,5-Trimethyl-2,4,6-tris(3,5-di-Tertiärbutyl-4Hydroxybenzyl)-benzol sind besonders vorteilhaft.

Neutralisationsmittel sind vorzugsweise Calciumstearat und/oder Calciumcarbonat einer mittleren Teilchengröße von höchstens 0,7 µm, einer absoluten Teilchengröße von kleiner 10 µm und einer spezifischen Oberfläche von mindestens 40 $m^2/g$.

Die Erfindung betrifft weiterhin ein Verfahren zur Herstellung der erfindungsgemäßen Mehrschichtfolie nach dem an sich bekannten Coextrusionsverfahren.

Im Rahmen dieses Verfahrens wird so vorgegangen, daß die den einzelnen Schichten der Folie entsprechenden Schmelzen durch eine Flachdüse coextrudiert werden, die so erhaltene Folie zur Verfestigung auf einer oder mehreren Walze/n abgezogen wird, die Folie anschließend biaxial gestreckt (orientiert), die biaxial gestreckte Folie thermofixiert und gegebenenfalls an der zur Coronabehandlung vorgesehenen Oberflächenschicht coronabehandelt wird.

Die biaxiale Streckung (Orientierung) kann simultan oder aufeinanderfolgend durchgeführt werden, wobei die aufeinanderfolgende biaxiale Streckung, bei der zuerst längs (in Maschinenrichtung) und dann quer (senkrecht zur Maschinenrichtung) gestreckt wird, bevorzugt ist.

Zunächst wird wie beim Coextrusionsverfahren üblich das Polymere bzw. die Polymermischung der einzelnen Schichten in einem Extruder komprimiert und verflüssigt, wobei die gegebenenfalls zugesetzten Additive bereits im Polymer bzw. in der Polymermischung enthalten sein können. Die Schmelzen werden dann gleichzeitig durch eine Flachdüse (Breitschlitzdüse) gepreßt, und die ausgepreßte mehrschichtige Folie wird auf einer oder mehreren Abzugswalzen abgezogen, wobei sie abkühlt und sich verfestigt.

Die so erhaltene Folie wird dann längs und quer zur Extrusionsrichtung gestreckt, was zu einer Orientierung der Molekülketten führt. In Längsrichtung wird vorzugsweise 4:1 bis 7:1 und in Querrichtung vorzugsweise 8:1 bis 10:1 gestreckt. Das Längsstrecken wird man zweckmäßigerweise mit Hilfe zweier entsprechend dem angestrebten Streckverhältnis verschieden schnellaufender Walzen durchführen und das Querstrecken mit Hilfe eines entsprechenden Kluppenrahmens.

An die biaxiale Streckung der Folie schließt sich ihre Thermofixierung (Wärmebehandlung) an, wobei die Folie etwa 0,5 bis 10 s lang bei einer Temperatur von 140 bis 160 °C gehalten wird. Anschließend wird die Folie in üblicher Weise mit einer Aufwickeleinrichtung aufgewickelt.

Es hat sich als besonders günstig erwiesen, die Abzugswalze oder -walzen, durch die die ausgepreßte Folie auch abgekühlt und verfestigt wird, durch einen Heiz- und Kühlkreislauf bei einer Temperatur von 10 bis 100 °C, vorzugsweise 20 bis 60 °C, zu halten.

Die Temperaturen, bei denen Längs- und Querstreckung durchgeführt werden, können in einem relativ großen Bereich variieren und richten sich nach der jeweiligen Zusammensetzung der Deckschichtmischung. Im allgemeinen wird die Längsstreckung vorzugsweise bei 120 bis 150 °C und die Querstreckung vorzugsweise bei 155 bis 190 °C.

Gegebenenfalls kann/können wie oben erwähnt nach der biaxialen Streckung eine oder beide Oberfläche/n der Folie nach einer der bekannten Methoden corona- oder flammbehandelt werden. Die Behandlungsintensität liegt im Bereich von 38 bis 42 mN/m.

Bei der Coronabehandlung wird zweckmäßigerweise so vorgegangen, daß die Folie zwischen zwei als Elektroden dienenden Leiterelementen hindurchgeführt wird, wobei zwischen den Elektroden eine so hohe Spannung, meist Wechselspannung (etwa 5 bis 20 kV und 5 bis 30 kHz), angelegt ist, daß Sprüh- oder Coronaentladungen stattfinden können. Durch die Sprüh- oder Coronaentladung wird die Luft oberhalb der Folienoberfläche ionisiert und reagiert mit den Molekülen der Folienoberfläche, so daß polare Einlagerungen in der im wesentlichen unpolaren Polymermatrix entstehen.

Für eine Flammbehandlung mit polarisierter Flamme (vgl. US-A-4,622,237) wird eine elektrische Gleichspannung zwischen einem Brenner (negativer Pol) und einer Kühlwalze angelegt. Die Höhe der angelegten Spannung beträgt zwischen 500 und 3000 V, vorzugsweise liegt sie im Bereich von 1 500 bis 2000 V. Durch die angelegte Spannung erhalten die ionisierten Atome eine erhöhte Beschleunigung und treffen mit größerer kinetischer Energie auf die Polymeroberfläche. Die chemischen Bindungen innerhalb des Polymermoleküls werden leichter aufgebrochen, und die Radikalbildung geht schneller vonstatten. Die thermische Belastung des Polymeren ist hierbei weitaus geringer als bei der Standardflammbehandlung, und es können Folien erhalten werden, bei denen die Siegeleigenschaften der behandelten Seite sogar besser sind als diejenigen der nicht behandelten Seite.

Die erfindungsgemäße Mehrschichtfolie zeichnet sich durch eine sehr homogene Folienoptik, einen charakteristischen matten Glanz und eine hervorragende gleichmäßige Metallisierbarkeit aus.

Es wurde gefunden, daß bei Einarbeitung der oben beschriebenen Polyethylene in eine Propylenhomopolymer-, Propylencopolymer- bzw. Propylenterpolymer-Deckschicht überraschenderweise eine sehr homogene Folienoptik mit der gewünschten matten Charakteristik erzielt werden konnte. Dieses Ergebnis überraschte umsomehr als Versuche ausgehend von der EP-A-0 367 613 nicht das erwünschte Ergebnis lieferten. Bei der Nacharbeitung der dort beschriebenen Folie, jedoch ohne Füllstoff in der Basisschicht, wurde eine Folie erhalten, deren Basisschicht zwar nicht mehr vakuolenhaltig, d. h. nicht mehr opak war, die jedoch ein fleckiges Aussehen hatte, welches bei der Metallisierung nicht überdeckt, sondern übertragen wurde. Weder die Folie selbst noch die durch sie übertragene Metallschicht hatten eine gleichmäßige matte Erscheinung. Die Trübung dieser Folie betrug stellenweise weniger als 10, wenn auch an anderen Punkten Trübungen größer 10 gefunden wurden (nach ASTM-D 1003). Ebenso ungleichmäßig waren die Glanzwerte. Insgesamt wurde keine Folie erhalten, welche nach Glanz, Trübung und der Gleichmäßigkeit ihres Aussehens der Anforderung "matt" genügte.

Die erfindungsgemäßen Folien zeigen dann das gewünschte optische Erscheinungsbild 'matt', wenn die Folie eine möglichst gleichmäßige Optik aufweist und wenn Glanz und Trübung der Folien geringe bzw. hohe Meßwerte haben, aber nicht minimal bzw. maximal sind. Es wurde gefunden, daß Folien mit Glanzwerten (bei einem Meßwinkel von 85°, gemessen nach ASTM-D-523-78) von kleiner 80, vorzugsweise kleiner 60, und einer Trübung (gemessen nach ASTM-D-1003) von größer 10, vorzugsweise größer 30, matt sind, wobei die jeweiligen Werte für Glanz und Trübung bei einer Ausführungsform nur innerhalb relativ enger Grenzen schwanken, d. h. maximal um 20 %. Besonders gut wird diese Anforderung erfüllt, wenn der Glanz im Bereich von 25 bis 45 (85°, ASTM-D-5237) und die Trübung im Bereich von 40 bis 80, vorzugsweise 50 bis 70, liegen und die Schwankungen von Glanz und Trübung über die gesamte Folie kleiner 10 %, vorzugsweise 1 bis 8 %, betragen.

Überraschenderweise läßt sich die matte Oberfläche der erfindungsgemäßen Folie hervorragend gleichmäßig metallisieren. Dabei bleibt der gleichmäßige matte Charakter der Folienoberfläche bei der Metallisierung erhalten.

Die Folie ist bezüglich ihrer antistatischen Eigenschaften deutlich verbessert. Es treten kaum mehr Blitzfiguren auf. Sowohl die metallisierte Folie als auch die übertragene Metallschicht zeigen nahezu keine Störstellen mehr.

Die Metallschicht läßt sich hervorragend von der neuen Deckschichtzusammensetzung übertragen, wobei deren matter Charakter erhalten bleibt. Dabei zeichnet sich die Folie gleichzeitig durch eine hohe Wiederverwendungsrate und ein sehr gutes Wickelverhalten aus.

Überraschenderweise migriert das an sich bekannte Additivdepot mit ausreichender Geschwindigkeit und in der notwendigen Konzentration in die HDPE-haltige Deckschicht. Da das Migrationsverhalten von Additiven in Polymeren zum einen eine Funktion der Additive selbst und deren Konzentration und zum anderen eine Funktion der Polymermatrix ist, in der die Additive migrieren, war es nicht vorhersehbar, daß das Depot aus Aminen und Amiden in der Folie mit einer neuen Deckschichtzusammensetzung das gleiche Migrationsverhalten aufweisen würde.

Zusammenfassend ist festzustellen, daß sich die erfindungsgemaße Mehrschichtfolie durch eine Vielzahl vorteilhafter Eigenschaften auszeichnet, welche sie für ihren bevorzugten Verwendungszweck als Transfermetallisierungsfolie besonders geeignet macht, insbesondere durch

- einen charakteristischen matten Glanz von kleiner 80 bei einem Meßwinkel von 85° (ASTM-D-523-78),
- eine optimierte Trübung von größer 10 (ASTM-D-1003),
- eine besonders gleichmäßige Folienoptik,
- eine große Rauhigkeit der Oberfläche,
- einen 'relativ' kleinen Reibungskoeffizienten,
- eine gute gleichmäßige Metallisierbarkeit,
- eine geringe Anzahl an Blitzfiguren,
- ein hervorragendes Wickelverhalten und
- eine hohe Wiederverwendungsrate.

Bei der Verwendung der Folie zur Metallisierung von flächenhaftem Trägermaterial wie Papier, Karton oder Glas wird das Verfahren in üblicher Weise durchgeführt. Die Folie wird im Hochvakuum mit Metall bedampft. Auf die Metallschicht des Folien-Metall-Materials oder auf die mit der Metallschicht zu versehende Oberfläche des flächenhaften Trägermaterials wird eine Klebstoffschicht aufgebracht und der Verbund aus Folie-Metall-Klebstoffschicht-Trägermaterial hergestellt. Nach dem Aushärten des Klebstoffs, das bei der Lagerung der Folie oder "in-line" durch Elektronenstrahlen erfolgt, wird die Folie abgezogen, aufgewik-

kelt und erneut in diesen Prozeß eingesetzt. Bei dem erhaltenen Verbund aus Metall und flächenhaftem Trägermaterial zeigt die metallische Oberfläche einen gleichmäßigen matten Glanz; der Glanzwert ist kleiner als 90 %, insbesondere kleiner als 60 % (Meßwinkel 85°). Sie läßt sich ausgezeichnet bedrucken.

Als Metalle kommen insbesondere Metalle wie Gold, Silber, Kupfer, Nickel, Zinn oder Aluminium in Frage, gegebenenfalls auch Gemische oder Legierungen von wenigstens zweien dieser genannten Metalle, bevorzugt geeignet ist Aluminium. Die Metalle werden üblicherweise mit einer Schichtdicke von 5 bis 500 nm aufgebracht, je nachdem auf welche Art von Substrat die Metallschicht übertragen werden soll. Üblicherweise liegt die Dicke der Metallschicht im Bereich von 10 bis 60 nm.

Verfahren zum Aufbringen der beschriebenen Metallschicht sind bekannt; dieses kann beispielsweise durch Vakuumabscheidung, Kathodenaufsprühung, Plasmaaufsprühung, Dampfphasenplattierung, stromfreie Plattierung, Elektroplattierung und Aufziehen entweder allein oder in Kombination ausgebildet werden. Das Vakuumabscheidungsverfahren wird besonders für technische Arbeitsgänge bevorzugt.

Die Erfindung wird nun anhand von Ausführungsbeispielen gemäß der nachstehenden Tabelle 1 noch näher erläutert.

Tabelle 1

| (Beispiele 1 bis 11) | | | |
|---|---|---|---|
| | Komponente I | Komponente II | I:II |
| B1 | $C_3$-Homopolymerisat | HDPE + $C_3$-Homopolmyerisat | 50:50 |
| B2 | $C_2/C_3$-Copolymerisat | HDPE + $C_3$-Homopolymerisat | 50:50 |
| B3 | $C_2/C_3$-Copolymerisat | HDPE + $C_3$-Homopolymerisat | 70:30 |
| B4 | $C_2/C_3/C_4$-Terpolymerisat + $C_3/C_4$-Copolymerisat | HDPE + $C_2/C_3$-Copolymerisat | 60:40 |
| B5 | $C_2/C_3$-Copolymerisat | HDPE + $C_2/C_3$-Copolymerisat | 50:50 |
| B6 | $C_2/C_3$-Copolymerisat | HDPE + $C_2/C_3$-Copolymerisat | 70:30 |
| 67 | $C_2/C_3$-Copolymerisat | HDPE + $C_2/C_3/C_4$-Terpolymerisat | 50:50 |
| B8 | $C_2/C_3$-Copolymerisat | HDPE + $C_2/C_3/C_4$-Terpolymerisat | 70:30 |
| B9 | $C_2/C_3$-Copolymerisat | HDPE + $C_2/C_3/C_4$-Terpolymerisat | 50:50 |
| | | + $C_3/C_4$-Copolymerisat | |
| B10 | $C_2/C_3/C_4$-Terpolymerisat | HDPE + $C_2/C_3/C_4$-Terpolymerisat + $C_3/C_4$-Copolymerisat | 50:50 |
| B11 | $C_2/c_3/C_4$-Terpolymerisat | HDPE + $C_2/C_3/C_4$-Terpolymerisat | 50:50 |
| B12 | $C_3$-Homopolymerisat | HDPE | 50:50 |
| B13 | $C_2/C_3$-Copolymerisat | HDPE | 50:50 |
| B14 | $C_2/C_3$-Copolymerisat | HDPE | 70:30 |
| B15 | $C_2/C_3/C_4$-Terpolymerisat | HDPE | 50:50 |
| B16 | $C_2/C_3/C_4$-Terpolymerisat | HDPE | 70:30 |
| B = Beispiel | | | |

**Beispiel 1**

Nach dem Coextrusionsverfahren wurde aus einer Breitschlitzdüse bei einer Extrusionstemperatur von 260 °C als Summe eine 1 mm dicke Dreischichtfolie mit einem Schichtaufbau XZX extrudiert, d. h. die Basisschicht Z war von zwei gleichen Deckschichten X umgeben.

Die Basisschicht bestand im wesentlichen aus einem Propylenhomopolymerisat mit einem n-heptanlöslichen Anteil von 4,5 Gew.-% und einem Schmelzpunkt von 165 °C. Der Schmelzflußindex des Propylenhomopolymeren lag bei 3,2 g/10 min bei 230 °C und 21,6 N Belastung (DIN 53 735). Zusätzlich enthielt die

Basisschicht 0,22 Gew.-% eines N,N-bis(hydroxyethyl)-($C_{10}$-$C_{20}$)-alkylamins (®Armostat 300) und 0,25 Gew.-% Stearinsäureamid.

Die beiden Deckschichten X bestanden im wesentlichen aus einer mechanischen Mischung aus den Komponenten I und II im Verhältnis I:II = 50:50.

Komponente I bestand aus einem Propylenhomopolymerisat mit einem n-heptanlöslichen Anteil von 4,5 Gew.-% und einem Schmelzpunkt von 165 °C. Der Schmelzflußindex des Propylenhomopolymeren lag bei 6,0 g/10 min bei 230 °C und 21,6 N Belastung (DIN 53 735).

Komponente II bestand aus einem Blend zweier Komponenten A und B im Verhältnis A:B = 50:50. Die Komponente A bestand aus einem HDPE mit einem MFI (50 N/190 °C) von 11 g/10 min (gemessen nach DIN 53 735), einer Viskositätszahl von 160 $cm^3/g$ (gemessen nach DIN 53 728, Teil 4), einer Dichte von 0,954 $g/cm^3$ (gemessen nach DIN 53 479, Verfahren A), einem Kristallisationsgrad von 68 % und einem Schmelzpunkt von 132 °C nach DSC-Messung. Die Komponente B bestand aus einem Propylenhomopolymerisat mit einem n-heptanlöslichen Anteil von 4,5 Gew.-% und einem Schmelzpunkt von 165 °C. Der Schmelzflußindex der Komponente B lag bei 7,0 g/10 min bei 230 °C und 21,6 N Belastung (DIN 53 735).

Die Komponenten I und II wurden im Verhältnis I:II = 50:50 in einem Henschel-Mischer 2 min lang bei 500 Upm mechanisch gemischt, so daß eine homogene Granulatmischung resultiert.

Alle Schichten enthielten zur Stabilisierung 0,12 Gew.-% Pentaerythrityl-Tetrakis-4-(3,5-ditertiärbutyl-4-hydroxyphenyl)-propionat (®Irganox 1010) sowie als Neutralisationsmittel 0,06 Gew.-% Calciumstearat.

Die extrudierte Dreischichtfolie wurde über die entsprechenden Verfahrensschritte nach der Coextrusion über eine erste Abzugswalze und ein weiteres Walzentrio abgezogen und abgekühlt, anschließend längsgestreckt, quergestreckt, fixiert und coronabehandelt, wobei im einzelnen die folgenden Bedingungen gewählt wurden:

| | |
|---|---|
| Extrusion: | Extrusionstemperatur 260 °C |
| | Temperatur der ersten Abzugswalze 50 °C |
| | Temperatur des Walzentrios 50 °C |
| Längsstreckung: | Streckwalze T = 125 °C |
| | Längsstreckung um den Faktor 5 |
| Querstreckung: | Aufheizfelder T = 175 °C |
| | Streckfelder T = 165 °C |
| | Querstreckung um den Faktor 10 |
| Fixierung: | Temperatur T = 155 °C |
| Coronabehandlung: | Spannung: 10 000 V |
| | Frequenz: 10 000 Hz |

Die so hergestellte Mehrschichtfolie hatte beidseitig eine matte Oberfläche und wies direkt nach der Herstellung eine Oberflächenspannung von 40 bis 41 mN/m auf.

Die Folie war ca. 21,5 µm dick, wobei die Basisschicht 19 µm und jede Deckschicht 1,25 µm Dicke hatte.

**Beispiel 2**

Beispiel 1 wurde wiederholt. Komponente I bestand aus einem statistischen Ethylen-Propylen-Copolymeren mit einem Ethylengehalt von 5 Gew.-%, bezogen auf das Gewicht des Copolymeren. Der Schmelzpunkt des Copolymeren lag bei 134 °C, wobei der Schmelzflußindex 7,0 g/10 min betrug.

**Beispiel 3**

Beispiel 2 wurde wiederholt. Das Mischungsverhältnis der beiden Komponenten I und II betrug I:II = 70:30.

**Beispiel 4**

Beispiel 1 wurde wiederholt.

Komponente I bestand aus einem Polymerblend aus einem Ethylen-Propylen-Butylen-1-Terpolymeren und einem Propylen-Butylen-1-Copolymeren entsprechend einem Gehalt von 0,7 Gew.-% Ethylen, 81,3 Gew.-% Propylen und 18 Gew.-% Butylen, bezogen auf das Polymerblend.

Komponente II bestand aus einem Blend zweier Komponenten A und B im Verhältnis A:B = 50:50. Die Komponente A bestand aus einem HDPE mit einem MFI (50 N/190 °C) von 11 g/10 min (gemessen nach

DIN 53 735), einer Viskositätszahl von 160 $cm^3/g$ (gemessen nach DIN 53 728, Teil 4), einer Dichte von 0,954 $g/cm^3$ (gemessen nach DIN 53 479, Verfahren A), einem Kristallisationsgrad von 68 % und einem Schmelzpunkt von 132 °C nach DSC-Messung. Die Komponente B bestand aus einem statistischen Ethylen-Propylen-Copolymeren mit einem Ethylengehalt von 5 Gew.-%, bezogen auf das Gewicht des Copolymeren. Der Schmelzpunkt des Copolymeren lag bei 134 °C, wobei der Schmelzflußindex 7,0 g/10 min betrug.
Das Mischungsverhältnis der beiden Komponenten I und II betrug I:II = 60:40.

**Beispiel 5**

Beispiel 4 wurde wiederholt. Komponente I bestand aus einem statistischen Ethylen-Propylen-Copolymeren mit einem Ethylengehalt von 5 Gew.-%, bezogen auf das Gewicht des Copolymeren. Der Schmelzpunkt des Copolymeren lag bei 134 °C, wobei der Schmelzflußindex 7,0 g/10 min betrug.
Das Mischungsverhältnis der beiden Komponenten I und II betrug I:II = 50:50.

**Beispiel 6**

Beispiel 5 wurde wiederholt. Das Mischungsverhältnis der beiden Komponenten I und II betrug I:II = 70:30.

**Beispiel 7**

Beispiel 5 wurde wiederholt. Komponente II bestand aus einem Blend zweier Komponenten A und B im Verhältnis A:B = 50:50. Die Komponente A bestand aus einem HDPE mit einem MFI (50 N/190 °C) von 11 g/10 min (gemessen nach DIN 53 735), einer Viskositätszahl von 160 $cm^3/g$ (gemessen nach DIN 53 728, Teil 4), einer Dichte von 0,954 $g/cm^3$ (gemessen nach DIN 53 479, Verfahren A), einem Kristallisationsgrad von 68 % und einem Schmelzpunkt von 132 °C nach DSC-Messung. Die Komponente B bestand aus einem Terpolymeren aus Ethylen-, Propylen- und Butylen-1-Einheiten mit einem Ethylengehalt von 1,9 Gew.-% und einem Butylen-1-Gehalt von 8,4 Gew.-%, bezogen auf das Terpolymer.

**Beispiel 8**

Beispiel 7 wurde wiederholt. Das Mischungsverhältnis der beiden Komponenten I und II betrug I:II = 70:30.

**Beispiel 9**

Beispiel 5 wurde wiederholt. Komponente II bestand aus einem Blend zweier Komponenten A und B im Verhältnis A:B = 50:50. Die Komponente A bestand aus einem HDPE mit einem MFI (50 N/190 °C) von 11 g/10 min (gemessen nach DIN 53 735), einer Viskositätszahl von 160 $cm^3/g$ (gemessen nach DIN 53 728, Teil 4), einer Dichte von 0,954 $g/cm^3$ (gemessen nach DIN 53 479, Verfahren A), einem Kristallisationsgrad von 68 % und einem Schmelzpunkt von 132 °C nach DSC-Messung. Die Komponente B bestand aus einem Polymerblend aus einem Ethylen-Propylen-Butylen-1-Terpolymeren und einem Propylen-Butylen-1-Copolymeren entsprechend einem Gehalt von 0,7 Gew.-% Ethylen, 81,3 Gew.-% Propylen und 18 Gew.-% Butylen, bezogen auf das Polymerblend.

**Beispiel 10**

Beispiel 9 wurde wiederholt. Komponente I bestand aus einem Terpolymeren aus Ethylen-, Propylen- und Butylen-1-Einheiten mit einem Ethylengehalt von 1,9 Gew.-% und einem Butylen-1-Gehalt von 8,4 Gew.-%, bezogen auf das Terpolymer.

**Beispiel 11**

Beispiel 7 wurde wiederholt. Komponente I bestand aus einem Terpolymeren aus Ethylen-, Propylen- und Butylen-1-Einheiten mit einem Ethylengehalt von 1,9 Gew.-% und einem Butylen-1-Gehalt von 8,4 Gew.-%, bezogen auf das Terpolymer.

**Beispiel 12**

Beispiel 1 wurde wiederholt. Die Komponente II bestand aus dem reinen HDPE mit einem MFI (50 N/190 °C) von 11 g/10 min (gemessen nach DIN 53 735), einer Viskositätszahl von 160 $cm^3/g$ (gemessen nach DIN 53 728, Teil 4), einer Dichte von 0,954 $g/cm^3$ (gemessen nach DIN 53 479, Verfahren A), einem Kristallisationsgrad von 68 % und einem Schmelzpunkt von 132 °C nach DSC-Messung.

**Beispiel 13**

Beispiel 2 wurde wiederholt. Die Komponente II entsprach der des Beispiels 12.

**Beispiel 14**

Beispiel 3 wurde wiederholt. Die Komponente II entsprach der des Beispiels 12.

**Beispiel 15**

Beispiel 11 wurde wiederholt. Die Komponente II entsprach der des Beispiels 12.

**Beispiel 16**

Beispiel 15 wurde wiederholt. Das Mischungsverhältnis der beiden Komponenten I und II betrug I:II = 70:30.

Zur Charakterisierung der Rohstoffe und der Folien wurden die folgenden Meßmethoden benutzt:

Schmelzflußindex

Der Schmelzflußindex wurde in Anlehnung an DIN 53 735 bei 21,6 N Belastung und 230 °C bzw. bei 50 N Belastung und 190 °C gemessen.

Schmelzpunkt

DSC-Messung, Maximum der Schmelzkurve, Aufheizgeschwindigkeit 20 °C/min.

Viskositätszahl J

Die Viskositätszahl ist ein Maß für die Molmasse. Die Viskositätszahl wird nach DIN 53 728, Teil 4, in 0,1%iger Dekahydronaphthalin-Lösung bei 135 °C gemessen.

Dichte $\rho$

Die Dichte wird nach DIN 53 479, Verfahren A, bestimmt.

Kristallisationsgrad $\alpha$

Der Kristallisationsgrad läßt sich durch folgende Beziehung ermitteln:

$$\alpha = \frac{\rho - \rho_{amorph}}{\rho_{kristallin} - \rho_{amorph}} \cdot 100\ \%$$

mit

$\rho_{amorph}$ = 0,8549 $g/cm^3$
$\rho_{kristallin}$ = 1,0005 $g/cm^3$
$\rho$ = Dichte des eingesetzten HDPE-Typs

Trübung

Die Trübung der Folie wurde in Anlehnung an ASTM-D 1003-52 gemessen.

Glanz

Der Glanz wurde nach DIN 67 530 bestimmt. Gemessen wurde der Reflektorwert als optische Kenngröße für die Oberfläche einer Folie. Angelehnt an die Normen ASTM-D 523-78 und ISO 2813 wurde der Einstrahlwinkel mit 60° oder 85° eingestellt. Ein Lichtstrahl trifft unter dem eingestellten Einstrahlwinkel auf die ebene Prüffläche und wird von dieser reflektiert bzw. gestreut. Die auf den photoelektronischen Empfänger auffallenden Lichtstrahlen werden als proportionale elektrische Größe angezeigt. Der Meßwert ist dimensionslos und muß mit dem Einstrahlwinkel angegeben werden.

Siegelnahtfestigkeit

Zur Bestimmung wurden zwei 15 mm breite Folienstreifen übereinandergelegt und bei 130 °C, einer Siegelzeit von 0,5 s und einem Siegeldruck von 10 $mm^2$ (Gerät: Brugger Typ NDS, einseitig beheizte Siegelbacke) versiegelt. Die Siegelnahtfestigkeit wurde nach der T-Peel-Methode bestimmt.

Rauhigkeit

Die Rauhigkeit wurde in Anlehnung an DIN 4768 bestimmt.

Reibung

Die Reibung wurde in Anlehnung an DIN 53 375 bestimmt.

Oberflächenspannung

Die Oberflächenspannung wurde mittels der sogenannten Tintenmethode (DIN 53 364) bestimmt.

Bedruckbarkeit

Die coronabehandelten Folien wurden 14 Tage nach ihrer Produktion (Kurzzeitbeurteilung) bzw. 6 Monate nach ihrer Produktion (Langzeitbeurteilung) bedruckt. Die Farbhaftung wurde mittels Klebebandtest beurteilt. Konnte mittels Klebeband wenig Farbe abgelöst werden, so wurde die Farbhaftung mit mäßig und bei deutlicher Farbablösung mit schlecht beurteilt.

Wasserdampfbarriere

Die Wasserdampfbarriere wird in Anlehnung an DIN 53 122 bei 23 °C und 85 % relativer Luftfeuchte gemessen und gibt die pro Quadratmeter und Tag durchgetretene Wassermenge in Gramm an.

In der nachstehenden Tabelle 2 sind die Eigenschaften der Polypropylenfolien der Beispiele zusammengefaßt.

## Tabelle 2

| Beispiel | Glanz (ASTM D-523-78) Meßwinkel 85° | Trübung (ASTM 1003) % | Rauhigkeit (c.o. 0,25 mm) µm | Reibungskoeffizient - | Oberflächenspannung nach 6 Monaten Lagerung mN/m | visuelle Beurteilung des matten Erscheinungsbildes (+ + = sehr gut) |
|---|---|---|---|---|---|---|
| B1 | 40 | 60 | 2,5 | 0,5 | 38 | + + |
| B2 | 32 | 66 | 3,0 | 0,4 | 39 | + + |
| B3 | 42 | 58 | 2,3 | 0,5 | 38 | + + |
| B4 | 38 | 62 | 2,6 | 0,4 | 39 | + + |
| B5 | 30 | 68 | 3,2 | 0,3 | 39 | + + |
| B6 | 38 | 63 | 2,6 | 0,4 | 39 | + + |
| B7 | 32 | 65 | 2,9 | 0,4 | 39 | + + |
| B8 | 38 | 62 | 2,7 | 0,4 | 39 | + + |
| B9 | 34 | 63 | 3,3 | 0,4 | 39 | + + |
| B10 | 36 | 62 | 2,6 | 0,4 | 39 | + + |
| B11 | 35 | 62 | 2,6 | 0,4 | 39 | + + |
| B12 | 31 | 68 | 3,0 | 0,4 | 38 | + + |
| B13 | 29 | 70 | 3,2 | 0,3 | 39 | + + |
| B14 | 32 | 66 | 2,8 | 0,3 | 39 | + + |
| B15 | 30 | 68 | 3,0 | 0,3 | 39 | + + |
| B16 | 34 | 64 | 2,8 | 0,4 | 39 | + + |

## Patentansprüche

**1.** Polypropylen-Mehrschichtfolie, welche mindestens eine Basisschicht, enthaltend Polypropylen und migrierende Additive oder eine Mischung aus migrierenden Additiven, und mindestens eine Deckschicht umfaßt, welche eine Mischung bzw. ein Blend zweier Komponenten I und II enthält, dadurch gekennzeichnet, daß

die Komponente I im wesentlichen
ein Propylenhomopolymeres oder
ein Copolymeres von

Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder
ein Terpolymeres von
Ethylen und Propylen und Butylen oder
Ethylen und Propylen und einem anderen α-Olefin mit 5 bis 10 Kohlenstoffatomen oder
eine Mischung aus zwei oder mehreren der genannten Homo-, Co- und Terpolymeren oder
ein Blend aus zwei oder mehreren der genannten Homo-, Co- und Terpolymeren, gegebenenfalls gemischt mit einem oder mehreren der genannten Homo-, Co- und Terpolymeren,
enthält und
die Komponente II im wesentlichen ein HDPE oder ein Blend zweier Blendkomponenten A und B enthält, wobei
die Blendkomponente A im wesentlichen
ein HDPE ist und
die Blendkomponente B im wesentlichen
ein Propylenhomopolymeres oder
ein Copolymeres von
Ethylen und Propylen oder
Ethylen und Butylen oder
Propylen und Butylen oder
Ethylen und einem anderen α-Olefin mit 5 bis 10 Kohlenstoffatomen oder
Propylen und einem anderen α-Olefin mit 5 bis 10 Kohlenstoffatomen oder
ein Terpolymeres von
Ethylen und Propylen und Butylen oder
Ethylen und Propylen und einem anderen α-Olefin mit 5 bis 10 Kohlenstoffatomen oder
eine Mischung aus zwei oder mehreren der genannten Homo-, Co- und Terpolymeren oder
ein Blend aus zwei oder mehreren der genannten Homo-, Co- und Terpolymeren
ist und die Folie matt ist.

**2.** Polypropylen-Mehrschichtfolie gemäß Anspruch 1, dadurch gekennzeichnet, daß
die Komponente I im wesentlichen
ein Propylenhomopolymeres ist oder
ein Copolymeres von
Ethylen und Propylen oder
Ethylen und Butylen-1 oder
Propylen und Butylen-1 oder
ein Terpolymeres von
Ethylen und Propylen und Butylen-1 oder eine Mischung aus zwei oder mehreren der genannten besonders bevorzugten Homo-, Co- Terpolymeren oder
ein Blend aus zwei oder mehreren der genannten besonders bevorzugten Homo-, Co- und Terpolymeren, gegebenenfalls gemischt mit einem oder mehreren der genannten Homo-, Co- und Terpolymeren,
wobei insbesondere Propylenhomopolymer oder
statistische Ethylen-Propylen-Copolymere mit
einem Ethylengehalt von 2 bis 10 Gew.-%, bevorzugt 5 bis 8 Gew.-%, oder
statistische Propylen-Butylen-1-Copolymere mit
einem Butylengehalt von 4 bis 25 Gew.-%, bevorzugt 10 bis 20 Gew.-%,
jeweils bezogen auf das Gesamtgewicht des Copolymeren, oder statistische Ethylen-Propylen-Butylen-1-Terpolymere mit
einem Ethylengehalt von 1 bis 10 Gew.-%, bevorzugt 2 bis 6 Gew.-%, und
einem Butylen-1-Gehalt von 3 bis 20 Gew.-%, bevorzugt 8 bis 10 Gew.-%,
jeweils bezogen auf das Gesamtgewicht des Terpolymeren, oder
ein Blend aus einem Ethylen-Propylen-Butylen-1-Terpolymeren und
einem Propylen-Butylen-1-Copolymeren
mit einem Ethylengehalt von 0,1 bis 7 Gew.-%
und einem Propylengehalt von 50 bis 90 Gew.-%

und einem Butylen-1-Gehalt von 10 bis 40 Gew.-%,
jeweils bezogen auf das Gesamtgewicht des Polymerblends,
bevorzugt sind, und
die Blendkomponente B im wesentlichen
ein Propylenhomopolymeres ist oder
ein Copolymeres von
Ethylen und Propylen oder
Ethylen und Butylen-1 oder
Propylen und Butylen-1 oder
ein Terpolymeres von
Ethylen und Propylen und Butylen-1 oder eine Mischung aus zwei oder mehreren der genannten besonders bevorzugten Homo-, Co- und Terpolymeren oder
ein Blend aus zwei oder mehreren der genannten besonders bevorzugten Homo-, Co- und Terpolymeren,
wobei insbesondere Propylenhomopolymer oder
statistische Ethylen-Propylen-Copolymere mit
einem Ethylengehalt von 2 bis 10 Gew.-%, bevorzugt 5 bis 8 Gew.-%, oder
statistische Propylen-Butylen-1-Copolymere mit
einem Butylengehalt von 4 bis 25 Gew.-%, bevorzugt 10 bis 20 Gew.-%,
jeweils bezogen auf das Gesamtgewicht des Copolymeren, oder statistische Ethylen-Propylen-Butylen-1-Terpolymere mit
einem Ethylengehalt von 1 bis 10 Gew.-%, bevorzugt 2 bis 6 Gew.-%, und
einem Butylen-1-Gehalt von 3 bis 20 Gew.-%, bevorzugt 8 bis 10 Gew.-%,
jeweils bezogen auf das Gesamtgewicht des Terpolymeren, oder
ein Blend aus einem Ethylen-Propylen-Butylen-1-Terpolymeren und
einem Propylen-Butylen-1-Copolymeren
mit einem Ethylengehalt von 0,1 bis 7 Gew.-%
und einem Propylengehalt von 50 bis 90 Gew.-%
und einem Butylen-1-Gehalt von 10 bis 40 Gew.-%,
jeweils bezogen auf das Gesamtgewicht des Polymerblends, bevorzugt sind.

**3.** Polypropylen-Mehrschichtfolie gemäß Anspruch 1 und/oder 2, dadurch gekennzeichnet, daß das HDPE einen MFI (50 N/190 °C) von 0,2 bis 50 g/10 min (gemessen nach DIN 53 735), eine Viskositätszahl von 100 bis 450 $cm^3/g$ (gemessen nach DIN 53 728, Teil 4), eine Dichte von 0,93 bis 0,97 $g/cm^3$ (gemessen nach DIN 53 479, Verfahren A), einen Kristallisationsgrad von 35 bis 80 % und einen Schmelzpunkt von 120 bis 150 °C nach DSC-Messung aufweist.

**4.** Polypropylen-Mehrschichtfolie gemäß einem oder mehreren der Ansprüche 1 bis 3, dadurch gekennzeichnet, daß das Verhältnis der Blendkomponenten A und B im Bereich von A:B = 20:80 bis A:B = 80:20, vorzugsweise zwischen A:B = 40:60 und A:B = 60:40, liegt.

**5.** Polypropylen-Mehrschichtfolie gemäß einem oder mehreren der Ansprüche 1 bis 4, dadurch gekennzeichnet, daß das Blend einen Schmelzflußindex von 1,5 bis 12 g/10 min, vorzugsweise 2,5 bis 6 g/10 min, (230 °C, 21,6 N Belastung) hat.

**6.** Polypropylen-Mehrschichtfolie gemäß einem oder mehreren der Ansprüche 1 bis 5, dadurch gekennzeichnet, daß das Verhältnis der Komponenten I und II im Bereich von I:II = 90:10 bis I:II = 10:90 liegt.

**7.** Polypropylen-Mehrschichtfolie gemäß einem oder mehreren der Ansprüche 1 bis 6, dadurch gekennzeichnet, daß das Polypropylenpolymere der Basisschicht einen Schmelzpunkt von mindestens 140 °C besitzt und der Schmelzflußindex im Bereich von 0,5 bis 15 g/10 min liegt.

**8.** Polypropylen-Mehrschichtfolie gemäß einem oder mehreren der Ansprüche 1 bis 7, dadurch gekennzeichnet, daß die migrierenden Additive tertiäre aliphatische Amine und/oder Fettsäureamide sind.

**9.** Polypropylen-Mehrschichtfolie gemäß einem oder mehreren der Ansprüche 1 bis 8, dadurch gekennzeichnet, daß die migrierenden Additive oder die Mischung aus migrierenden Additiven in der Basisschicht in einer Menge von 0,05 bis 2 Gew.-% enthalten sind.

10. Polypropylen-Mehrschichtfolie gemäß einem oder mehreren der Ansprüche 1 bis 9, dadurch gekennzeichnet, daß die Mischung aus migrierenden Additiven tertiäre aliphatische Amine und Fettsäureamide umfaßt.

11. Polypropylen-Mehrschichtfolie gemäß einem oder mehreren der Ansprüche 1 bis 10, dadurch gekennzeichnet, daß die Basisschicht als Mischung aus migrierenden Additiven 0,15 bis 0,5 Gew.-% N,N-bis-(hydroxyethyl)-alkylamin und 0,15 bis 0,5 Gew.-% Stearinsäureamid enthält.

12. Verfahren zur Herstellung der Polypropylen-Mehrschichtfolie gemäß Anspruch 1, bei dem die den einzelnen Schichten der Folie entsprechenden Schmelzen durch eine Flachdüse coextrudiert werden, die coextrudierte Folie über eine Abzugswalze, deren Temperatur zwischen 40 und 100 °C liegt, abgezogen wird, die Folie biaxial gestreckt wird mit einem Längsstreckverhältnis von 4:1 bis 7:1 und einem Querstreckverhältnis von 8:1 bis 10:1, die biaxial gestreckte Folie thermofixiert, gegebenenfalls coronabehandelt und anschließend aufgewickelt wird, dadurch gekennzeichnet, daß die Folie mindestens eine matte Oberfläche aufweist.

13. Verfahren gemäß Anspruch 12, dadurch gekennzeichnet, daß die Längsstreckung der Folie bei 120 bis 150 °C und die Querstreckung bei 155 bis 190 °C durchgeführt wird.

14. Verwendung der Polypropylen-Mehrschichtfolie gemäß einem oder mehreren der Ansprüche 1 bis 11 für die Transfermetallisierung.

15. Verfahren zur Metallisierung von flächenhaftem Trägermaterial, insbesondere von Papier, Karton und Glas, bei dem die Metallschicht von einer Folie auf das Trägermaterial übertragen wird, dadurch gekennzeichnet, daß zur Übertragung der Metallschicht die Folie gemäß einem der Ansprüche 1 bis 11 eingesetzt wird.

16. Verfahren gemäß Anspruch 15, dadurch gekennzeichnet, daß die Metallschicht bedruckt wird.

Europäisches Patentamt

# EUROPÄISCHER RECHERCHENBERICHT

Nummer der Anmeldung
EP 94 10 5531

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| P,X | EP-A-0 563 796 (HOECHST AG)<br>* Ansprüche 1-13,19 *<br>* Seite 7, Zeile 16 - Zeile 34 *<br>--- | 1-10,12, 13 | B32B27/32 |
| P,X | EP-A-0 538 746 (HOECHST AG)<br>* Ansprüche 1-17,22 *<br>* Seite 3, Zeile 52 - Seite 4, Zeile 10 *<br>--- | 1-10,12, 13 | |
| P,X | EP-A-0 538 747 (HOECHST AG)<br>* Ansprüche 1-18,24 *<br>* Seite 4, Zeile 57 - Seite 5, Zeile 15 * | 1-10,12, 13 | |
| D | & DE-A-41 35 096 (HOECHST AG.)<br>--- | | |
| Y,D | EP-A-0 367 613 (CORTAULDS FILMS & PACKAGING)<br>* das ganze Dokument *<br>--- | 1-16 | |
| Y,D | EP-A-0 352 463 (HOECHST AG.)<br>* Spalte 2, Zeile 54 - Spalte 3, Zeile 52; Beispiel 1 *<br>--- | 1-16 | **RECHERCHIERTE SACHGEBIETE (Int.Cl.5)** |
| | | | B32B |
| A | PATENT ABSTRACTS OF JAPAN<br>vol. 16, no. 306 (M-1276)6. Juli 1992<br>& JP-A-04 086 260 (TOYO SEIKAN K. LTD.) 18. März 1991<br>* Zusammenfassung *<br>--- | 1-7 | |
| A | GB-A-2 125 802 (CHISSO CORP.)<br>* Seite 1, Zeile 65 - Seite 2, Zeile 47 *<br>---<br>-/-- | 1-7 | |

Der vorliegende Recherchenbericht wurde für alle Patentansprüche erstellt

| Recherchenort | Abschlußdatum der Recherche | Prüfer |
|---|---|---|
| DEN HAAG | 28. Juli 1994 | Ibarrola Torres, O |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)

Europäisches Patentamt

# EUROPÄISCHER RECHERCHENBERICHT

Nummer der Anmeldung
EP 94 10 5531

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | DATABASE WPI<br>Week 9141,<br>Derwent Publications Ltd., London, GB;<br>AN 91-298804<br>& JP-A-3 197 541 (IDEMITSU PETROCHEM. KK.)<br>28. August 1991<br>* Zusammenfassung *<br>----- | 1-7 | |

RECHERCHIERTE SACHGEBIETE (Int.Cl.5)

Der vorliegende Recherchenbericht wurde für alle Patentansprüche erstellt

| Recherchenort | Abschlußdatum der Recherche | Prüfer |
|---|---|---|
| DEN HAAG | 28. Juli 1994 | Ibarrola Torres, O |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument